# EUROPEAN PATENT APPLICATION

(11) **EP 3 293 742 A1**
(43) Date of publication of application: **14.03.2018**
(21) Application number: 17178205.5
(22) Date of filing: 27.06.2017
(51) Int. Cl.: H01F 19/04, H03H 1/00, H03H 7/00

(54) **INDUCTIVE COUPLING FOR ELECTROSTATIC DISCHARGE**

(30) Priority: 08.09.2016 US 201615259415
(71) Applicant: Nexperia B.V., 6534 AB Nijmegen (NL)
(72) Inventor: Schuett, Jennifer, 22529 Hamburg (DE); Ritter, Hans-Martin, 22529 Hamburg (DE); Notermans, Godfried Henricus Josephus, 22529 Hamburg (DE)
(74) Representative: Crawford, Andrew

(57) **Abstract**

An apparatus includes a first inductive component connected in series with a first signal line of a differential signal path and configured to suppress residual electrostatic discharge (ESD) current spikes on the first signal line by using a first effective inductance. A second inductive component is connected in series to a second signal line of the differential signal path configured to suppress residual ESD current spikes on a second signal line of the differential signal path by using a second effective inductance. The first and second inductive components are configured to pass differential signals on the differential signal path by using inductive coupling between the first and second inductive components to provide a third effective inductance.

## Description

Aspects of various embodiments are directed to the use of inductively coupled signal lines to provide protection for circuitry from electrostatic discharge (ESD) events.

ESD events can result in significant damage of circuit components and can result in eventual failure of the circuit. Certain technology advances, such as the increase in data speeds for input and output circuitry, can increase the susceptibility of the protected circuitry to harm from ESD events. Further, increases in data signal rates can result in more stringent requirements on the operational properties of ESD protection circuitry.

These and other matters have presented challenges to ESD protection circuit implementations, for a variety of applications.

### SUMMARY

Various example embodiments are directed to issues such as those addressed above and/or others which may become apparent from the following disclosure concerning ESD protection using inductive coupling.

In certain example embodiments, aspects of the present disclosure involve an apparatus that includes a first inductive component connected in series with a first signal line of a differential signal path and configured to suppress electrostatic discharge (ESD) current on the first signal line by using a first effective inductance. A second inductive component is connected in series to a second signal line of the differential signal path configured to suppress ESD current on a second signal line of the differential signal path by using a second effective inductance. The first and second inductive components are configured to pass differential signals on the differential signal path by using inductive coupling between the first and second inductive components to provide a third effective inductance.

Consistent with various embodiments, a method is provided that includes: receiving an electrostatic discharge (ESD) event on signal lines forming a differential signal path; suppressing frequency components of the ESD event above a cutoff frequency using effective inductance provided by inductive components connected in series with the signal lines; receiving a differential signal on the signal lines forming the differential signal path; and passing frequency components the differential signal above the cutoff frequency by using inductive coupling between the inductive components to reduce the effective inductance provided by the inductive components.

The above discussion/summary is not intended to describe each embodiment or every implementation of the present disclosure. The figures and detailed description that follow also exemplify various embodiments.

### BRIEF DESCRIPTION OF FIGURES

Various example embodiments may be more completely understood in consideration of the following detailed description in connection with the accompanying drawings, in which:
FIG. 1 is a block diagram of a system or apparatus with an inductive circuit designed to attenuate common-mode currents, consistent with embodiments of the present disclosure;
FIG. 2 is a block diagram of a system that includes ESD protection circuitry in combination with an inductive circuit designed to attenuate common-mode currents, consistent with embodiments of the present disclosure;
FIG. 3 is a block diagram of a system that includes two ESD protection circuits in combination with an inductive circuit designed to attenuate common-mode currents, consistent with embodiments of the present disclosure;
FIG. 4 is a block diagram of a system that includes three ESD protection circuits in combination with an inductive circuit designed to attenuate common-mode currents, consistent with embodiments of the present disclosure;
FIG. 5 depicts a pattern in which the inductors are arranged in concentric spirals, consistent with embodiments of the present disclosure;
FIG. 6 depicts a cross-sectional view of the inductor patterns from FIG. 5 the line A-A, consistent with embodiments of the present disclosure;
FIG. 7 depicts a pattern in which the inductor traces are arranged in concentric quadrilateral patterns, consistent with embodiments of the present disclosure;
FIG. 8 depicts a cross-sectional view of the inductor patterns from FIG. 7 and along the line A-A, consistent with embodiments of the present disclosure;
FIG. 9 depicts a pattern in which the inductor traces are arranged in stacked quadrilateral patterns, consistent with embodiments of the present disclosure;
FIG. 10 depicts a cross-sectional view of the inductors from FIG. 9 and along the line A-A, consistent with embodiments of the present disclosure;
FIG. 11 depicts a pattern in which the inductor traces are arranged as a spiral with straight lines, consistent with embodiments of the present disclosure;
FIG. 12 depicts a cross-sectional view of the inductors from FIG. 11 and along the line A-A, consistent with embodiments of the present disclosure; and
FIG. 13 depicts a flow diagram for using a system or apparatus with an inductive circuit designed to protect against ESD currents, consistent with embodiments of the present disclosure.

While various embodiments discussed herein are amenable to modifications and alternative forms, aspects thereof have been shown by way of example in the drawings and will be described in detail. It should be understood, however, that the intention is not to limit the disclosure to the particular embodiments described. On the contrary, the intention is to cover all modifications, equivalents, and alternatives falling within the scope of the disclosure including aspects defined in the claims. In addition, the term "example" as used throughout this application is only by way of illustration, and not limitation.

### DETAILED DESCRIPTION

Aspects of the present disclosure are believed to be applicable to a variety of different types of apparatuses, systems and methods involving ESD protection circuitry. In certain implementations, aspects of the present disclosure have been shown to be beneficial when used in the context of ESD protection for integrated circuit (IC) chips that use high speed differential signaling. In some embodiments, coupled inductors are placed on respective signal paths of a differential signal pair. While not necessarily so limited, various aspects may be appreciated through the following discussion of non-limiting examples which use exemplary contexts.

Accordingly, in the following description various specific details are set forth to describe specific examples presented herein. It should be apparent to one skilled in the art, however, that one or more other examples and/or variations of these examples may be practiced without all the specific details given below. In other instances, well known features have not been described in detail so as not to obscure the description of the examples herein. For ease of illustration, the same reference numerals may be used in different diagrams to refer to the same elements or additional instances of the same element. Also, although aspects and features may in some cases be described in individual figures, it will be appreciated that features from one figure or embodiment can be combined with features of another figure or embodiment even though the combination is not explicitly shown or explicitly described as a combination.

Various embodiments of the present disclosure are directed toward an inductive circuit that provides protection from residual ESD event current while passing communication or data signals transmitted using high-speed differential signals. In particular implementations, the inductive circuit uses inductive coupling between two inductive traces or coils to diminish the effective inductance for the differential-mode currents reducing the effective impedance (or reactance). Signals received as part of an ESD event are generally in the form of common mode currents, which are thereby attenuated by the inductive circuit.

Consistent with various embodiments, it has been recognized that an inductive circuit can be designed in a manner that allows for attenuation of high frequency components of common-mode currents from an ESD event while also passing similar high frequency components of differential-mode currents from data signals. For example, the inductive circuit can include two inductive components with respective windings or traces that are specifically designed to be strongly coupled at the relevant frequencies. In this manner, magnetic fields produced by differential-mode currents in the inductive coils counteract or cancel one another. Since the inductance of an inductor is a result in changes to an induced magnetic field, the inductance (and resulting impedance) seen by the differential-mode currents is reduced. Thus, the ESD common-mode currents are subjected to a significantly higher impedance and attenuated accordingly. Due in part to the difference in effective inductance for common-mode and differential-mode currents, the individual inductance value of each inductive component can be set to a value sufficient to provide meaningful attenuation of ESD currents without significantly impacting the data signals.

Particular aspects of the disclosed embodiments do not use a magnetic core between inductors of the inductive circuit. It has been recognized that a magnetic core can suffer from saturation effects for high frequency currents/signals. The saturation effects can reduce the effectiveness of the inductive circuit with respect to high-frequency components of the relevant signals. Various embodiments are directed toward coils that are magnetically coupled primarily due to their physical and geometric proximity in a manner that is effective for high frequencies, including frequencies extending well into the GHz range.

Certain embodiments are directed toward the use of one or more additional ESD protection circuits in combination with the inductive circuits described herein. As an example, the inductive circuits can be used to provide protection of input/output (I/O) circuitry that is part of an integrated circuit (IC) chip. The IC chip includes integrated ESD protection circuitry (e.g., circuitry that is on the die) for the corresponding I/O lines. The integrated ESD protection circuitry can be designed to shunt the majority of the ESD current to a reference voltage (e.g., to ground), while the inductive circuit attenuates residual, high-frequency ESD current. As discussed herein, some of the residual ESD current is not suppressed due to the inductance from the discharge path provided by the ESD protection circuitry. Because inductance increases with frequency, the residual ESD current can be particularly high when there are high frequency components (e.g., fast rise times) within an ESD event. The use of series inductors placed between the source of the ESD event and the ESD protection circuitry can serve to attenuate the residual current before it reaches the circuitry under protection.

It has been recognized that as technology has advanced, circuitry often becomes more susceptible to damage from exposure to ESD currents of short duration. For example, devices are being designed with increasingly thinner gate oxides, which can increase susceptibility to damage from ESD events. The issue can be particularly problematic with respect to circuitry designed for use with high speed data signals. For example, ESD protection circuitry that shunts high-frequency ESD currents can begin to interfere with data signals that approach or overlap in frequency. Accordingly, various embodiments are directed toward a combination of ESD protection circuitry designed to protect against a first (lower) frequency of ESD currents and inductive circuit designed to protect against a second (higher) frequency of ESD currents, while simultaneously passing the second frequency for differential-mode data signals.

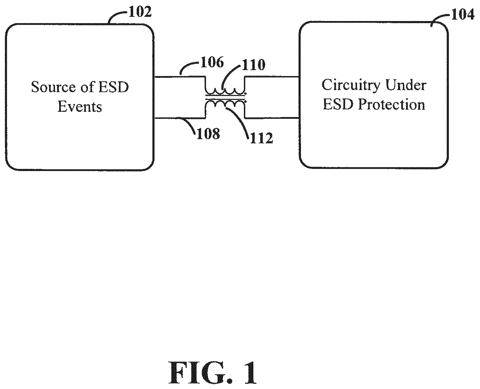

Turning now to the figures, FIG. 1 is a block diagram of a system or apparatus with an inductive circuit designed to attenuate ESD currents, consistent with embodiments of the present disclosure. The depicted apparatus includes circuitry 104 that is to be protected from ESD events. Consistent with various embodiments, the circuitry 104 can be located on an IC chip and exposed to ESD events through I/O pins, pads, or other external electrical connections (referred to as simply "I/O"). The protection is not limited to use with circuitry located on an IC chip; however, an IC chip is often referred to for ease of discussion.

The circuitry 104 can be configured to communicate (receive, transmit, or both) using a differential signal that is present on two different conductive signal lines 106 and 108. The use of differential signaling is particularly prevalent for high-speed data rates, such as data rates associated with the Universal Serial Bus (USB) 3.1, which is mentioned as a non-limiting example of a signal protocol offering data transfer rates in the Gbit/s range.

FIG. 1 shows a source of ESD events 102, which represents any number of structures capable of generating ESD events on the differential signal lines 106 and 108. There are any number of different possible structures that can accumulate a charge sufficient to create an ESD event (e.g., the human body, parts of the overall system, and other objects that come in close proximity). Certain standards have been developed to simulate ESD events from different sources and under different conditions. For example, the human body model (HBM) attempts to simulate ESD events caused by electrical contact with the human body; the charged device model (CDM) attempts to simulate direct or indirect charging of a protected device through the triboeffect or electrostatic induction; and the machine model (MM) attempts to simulate a machine discharging through the protected device to ground. The IEC 61000-4-2 standard attempts to simulate discharge from a person through multiple different discharge profiles. Differences between the HBM and the discharge profiles of the IEC 61000-4-2 standard include the inclusion of a fast initial pulse with high peak current level, fast rise time, and short pulse duration. Aspects of the present disclosure are directed toward providing protection against ESD events that are consistent with such aspects of the IEC 61000-4-2 standard, while passing differential signals having similar or overlapping frequency components. The IEC 61000-4-2 standard defines an initial pulse rise time (from 10% to 90% of signal peaks) of 1 ns or less, and more particularly a rise time of about 600 ps.

According to embodiments, ESD protection can be provided using a first inductive component 110, which is shown as being connected in series with a first one of signal lines 106 for the differential signal path. The inductive component 110 is configured to suppress residual electrostatic discharge (ESD) current spikes on the first signal 106 line. A second inductive component 112 is connected in series to a second signal line 108 of the differential signal path. The second inductive component 112 is also configured to attenuate common-mode signals, including ESD current spikes, on the second signal line 108 of the differential signal based upon the corresponding second effective inductance for common-mode current on the differential signal path. The suppression provided by the inductive components is a result of the effective inductance for common-mode signals received on the differential signal pair.

For example, ESD protection circuitry is sometimes implemented using a multiple-stage network of ESD protection circuits. ESD stress is divided between the stages, allowing for the ESD protection circuits to have different properties (e.g., such as a lower clamping voltage for an ESD protection circuit that receives less of the ESD current than another ESD protection circuit). When the ESD protection circuit discharges or shunts the ESD event current to a reference voltage, intrinsic inductance of the discharge path can prevent high frequency components from being properly discharged. The result can be a residual ESD current that has the potential to damage sensitive circuitry. The inductive components 110, 112 can attenuate the residual ESD current by providing a series inductance that provides high impedance to high frequency signal components.

According to embodiments, the first and second inductive components are configured to pass differential signals on the differential signal path by using inductive coupling between the first and second inductive components. The coupling results in a third effective inductance relative to the collective signal. The third effective inductance is a reduced inductance relative to the first and second effective inductances for common-mode ESD currents. In particular, the coupling of magnetic fields between the two inductive components reduces the magnetic field generated by a given differential current, resulting in a corresponding reduction in the effective impedance for the inductors and a given change in current.

Consistent with various embodiments, the first and second inductive components are designed to have first and second effective inductances that are the same value so that attenuation is the same for each line of the differential signal. Practically speaking, the values will vary slightly due to a variety of factors, such as minor differences in coil layout and manufacturing variations.

According to various embodiments, the inductive components 110, 112 are implemented using respective inductive coils that are located on a common substrate. The inductive coils can be inductively coupled to each other by physically and geometrically arranging portions of the coils in close proximity. The inductive coils are also arranged so that their respective magnetic fields are additive (in the same direction) for signals having the same current direction (common-mode currents). In certain embodiments, the inductive coils can be planar coils that are routed parallel to each other for significant portions of their respective paths such that currents in equal and opposite direction (differential-mode currents) produce magnetic fields in opposing directions. The amount that the fields are reduced for differential-mode currents is a direct result of the strength of the coupling between the inductors, which is sometimes referred to as the coupling factor. Various embodiments are directed toward inductive coils arranged in concentric or spiral patterns to provide sufficient coupling and inductance; however, other patterns are possible.

According to some embodiments, the use of planar spiral coils of suitable dimensions allows for the creation of inductances that are effective at high frequencies, including those frequencies corresponding to stress pulses the pose a threat to modern high-speed I/O circuitry (e.g., as may be consistent with the IEC 61000-4-2 standard). For instance, the planar spiral coils may be designed with widths of around 5 µm and spacing of about 10 µm between the coils in order to achieve a coupling factor of at least 0.9, and which may also include coupling factors of 0.94 or higher.

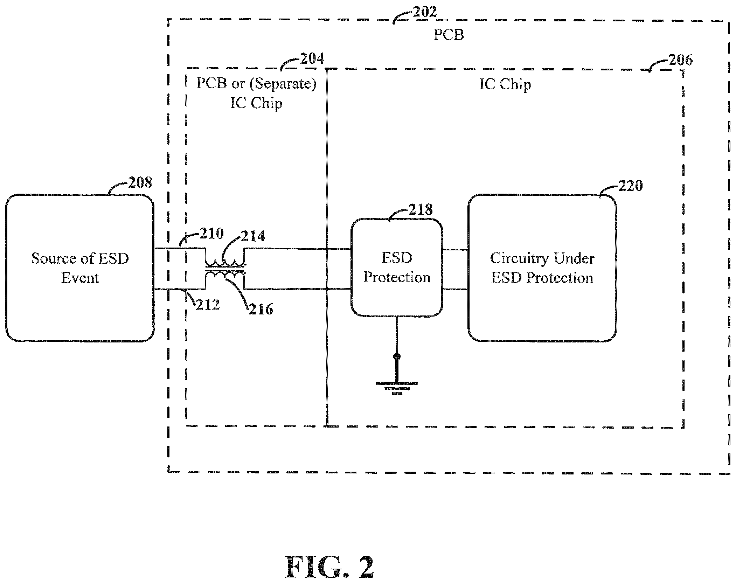

FIG. 2 is a block diagram of a system that includes ESD protection circuitry in combination with an inductive circuit designed to protect against residual ESD currents, consistent with embodiments of the present disclosure. Multiple levels of protection protect the circuitry 220 from ESD events received from ESD source 208 over the differential signal lines 210 and 212. The first level of protection is provided by ESD protection circuitry 218. ESD protection circuitry 218 can be configured to shunt ESD current to a reference voltage (e.g., to ground). Consistent with various embodiments, the ESD protection circuitry 218 can be implemented on-chip, using common ESD protection elements consistent with the particular IC manufacturing technology being used. The ESD protection circuitry 218 can be configured to shunt large transient currents when an ESD event is detected. The ESD protection circuit, however, may be insufficient to shunt current from an initial ESD spike that has a fast rise time and a short pulse duration (e.g., due to intrinsic inductance in the discharge path). This can lead to a residual ESD current that has the potential to damage the circuitry 220.

Inductive structure 204 includes inductor components 214 and 216 that are configured to operate with ESD protection circuitry 218 in order to attenuate residual ESD current, which can result from high frequency components of an ESD event. The inductor components 214 and 216 can thereby block and attenuate energy from the frequency components of the ESD event that generate the residual ESD current that would otherwise reach the IC chip 206. According to various embodiments of the present disclosure, the inductor components 214 and 216 are designed to suppress residual ESD current from reaching the IC chip 206 while also (simultaneously) passing differential-mode signals of the same frequency. This is accomplished by configuring the inductor components 214 and 216 to have an effective impedance for common-mode signals that is significantly greater than the effective impedance for differential-mode signals. Consistent with particular embodiments, the attenuated residual current is consistent with an ESD pulse of 30 A and 1 nanosecond in duration and also with data signals operating at 1-5 GHz (or even higher). Other embodiments contemplate frequency components consistent with 60A and 600 ps in duration. The attenuation may therefore be set to a suitable value (e.g., attenuation might be selected in a range from 1/20 to 1/30).

The IC chip 206 is shown as being located on a printed circuit board (PCB) 202. For instance, the IC chip could be connected (e.g., soldered) in different manners depending upon the particular package format used by the IC chip (e.g., surface mount packages, ball grid arrays, chip carrier packages, small outline packages, pin grid arrays, or flat packages).

In certain embodiments, the inductive structure 204, and the corresponding inductor components 214 and 216, is located on a separate IC chip that can also be placed on the PCB 202. For example, the inductive structure 204 can be a four pin package (two signal inputs and two signal outputs) within which inductive coils are located. The inductive coils can be designed with inductive values and a coupling factor that are collectively sufficient to provide the desired attenuation and signal passing capabilities.

According to various embodiments, the inductive structure 204 can be integrated directly into the PCB 202. For example, the inductor components 214 and 216 can be constructed with conductive traces having sufficient dimensions to produce the desired inductance and coupling.

Certain embodiments are directed toward placement of the inductive structure 204 within the same IC chip 206 package as the circuitry 220 under protection. For example, the inductor components 214 and 216 could be designed into a package substrate upon which the semiconductor die of the IC chip is placed.

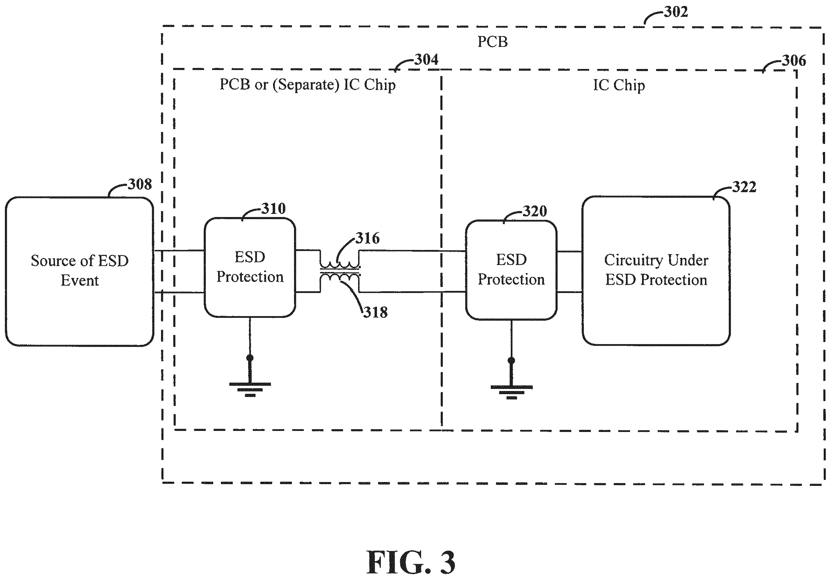

FIG. 3 is a block diagram of a system that includes two ESD protection circuits in combination with an inductive circuit designed to protect against ESD currents, consistent with embodiments of the present disclosure. Similar to the discussion of FIG. 2, the system of FIG. 3 includes a PCB 302 that that includes circuitry under ESD protection 322, an IC chip 306, on-chip ESD protection circuitry 320, and inductive structure 304. ESD events provided from the ESD source 308 are further protected by ESD protection circuitry 310. ESD protection circuitry 310 works in conjunction with ESD protection circuitry 320 to provide two layers of protection. The ESD current is divided between the two ESD protection circuits 310 and 320 base, in part, upon the effective impedance of coils 316 and 318. Thus, the ESD protection circuit 310 can help shunt the residual ESD current that is attenuated by the coils 316 and 318. For example, when the effective impedance is high, on-chip protection 320 will shunt a relative small amount of the total current, while the ESD protection circuit 310 will shunt the majority of the total current. The lower current levels at the on-chip protection circuit 320 can facilitate the use of a lower clamping voltage for the on-chip protection circuit 320 and thereby provide additional protection relative to a single ESD protection circuit designed to handle all of the ESD current.

According to various embodiments, the intrinsic inductance of the on-chip protection circuit 320 can (unintentionally) prevent some ESD current from being shunted to ground, particularly for high frequency components. The result can be a residual ESD current that has the potential to damage circuitry 322. The coils 316, 318 can suppress ESD current for such high frequency components, which has the effect of suppressing or attenuating the residual ESD current that would otherwise be seen by circuitry 322. The inductive ratio between the on-chip protection circuit 320 and the coils 316 and 318 can be set to control the amount of residual current that remains for a given ESD event. Consistent with certain embodiments, the inductance of the ESD protection circuitry 310 and 320 together with the effective inductance of the coils 316 and 318 further services to effectively attenuate a residual current that can result from high frequency parts of the remaining pulse. The result is less stress due to high frequency components of ESD events, which can improve the overall robustness of the total system to ESD events.

In some embodiments, the inductor components 316 and 318 are located on a separate IC chip from the IC chip 306. In some implementations, the separate chip can also include the ESD protection circuitry 310. For example, the separate chip can be implemented as a five pin package with two inputs, two output, and a ground or reference pin. In other implementations, the ESD protection circuitry 310 is not located on the separate chip. The ESD protection circuitry 310 might, for instance, be part of yet another IC chip, or be constructed from individual components (e.g., diodes) soldered directly to the PCB board.

Consistent with embodiments, the inductor components 316 and 318 can be implemented directly within the PCB 302, as discussed in connection with FIG. 2.

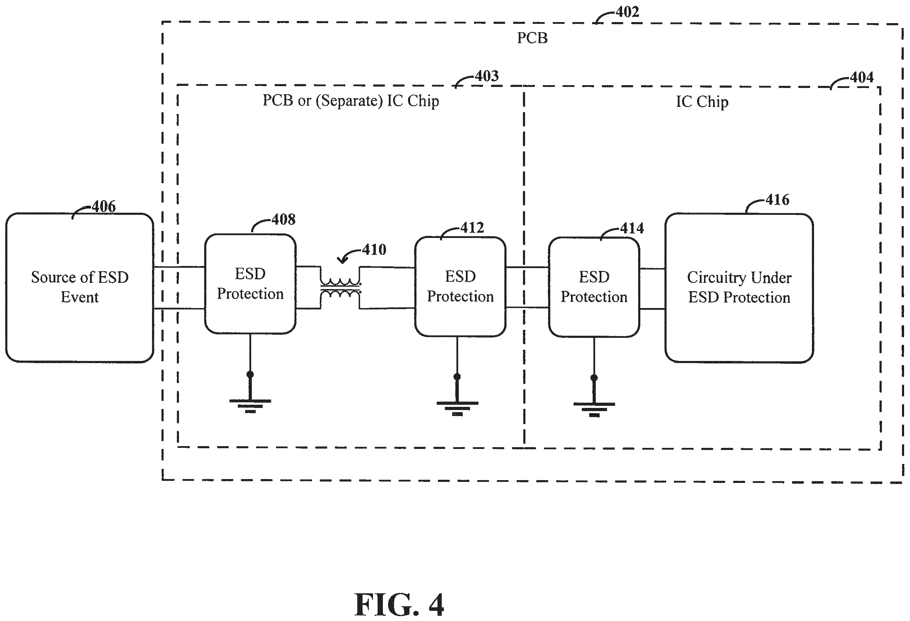

FIG. 4 is a block diagram of a system that includes three ESD protection circuits in combination with an inductive circuit designed to protect against ESD currents, consistent with embodiments of the present disclosure. The configuration of the system is similar to the configuration discussed in connection with FIG. 3, with an additional ESD protection circuit 412 placed between the inductors 410 and the on-chip ESD protection circuit 414. The additional ESD protection circuit 412 can be particularly useful for compensating for parasitic impedances between the first ESD protection circuit 408 and the internal ESD protection circuit 414 (e.g., due to signal routing within the PCB board 402). In particular, high board impedance might cause more current to be shunted by the first ESD protection circuit 408, which is located closer to the source 406 of the ESD event. This can provide additional protection for the circuitry 416.

The various components within the inductive structure 403 can be located in different locations depending on the desired implementation. For example, both ESD protection circuits 408 and 412 can be co-located with the inductors 410 as part of a single IC chip that is different than the IC chip 404. Alternatively, one or both of the ESD protection circuits 408 and 412 can be implemented using additional IC chips, or using individual components that are directly attached to the PCB, or combinations thereof.

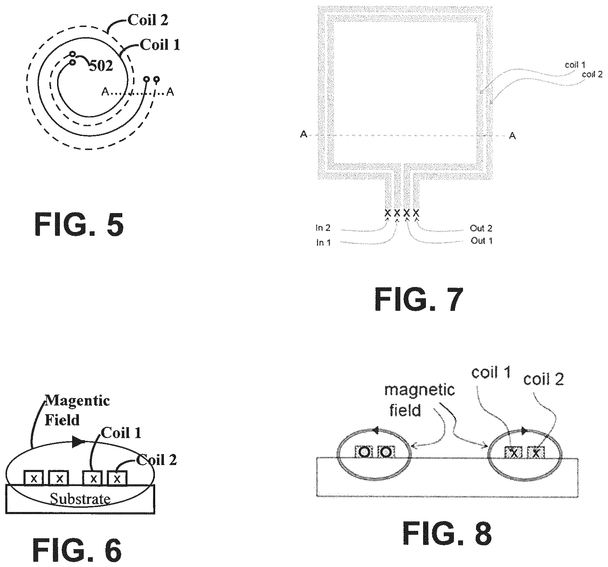

FIGs. 5-12 depict different views for planar inductor layout patterns, consistent with embodiments of the present disclosure. The particular layouts are provided as examples, and are not meant to limit the inductive components to any specific configuration or pattern. In particular examples, the inductors are located on top of a substrate and are electrically isolated from one another using various polymers (e.g., polyimides and (PI) and polybenzoxazole (PBO)). The inductive patterns are constructed from a conductive material, such as copper or coper alloys.

FIG. 5 depicts a pattern in which the inductors are arranged in concentric spirals, consistent with embodiments of the present disclosure. The trace thickness, spacing, and length can be set according to the desired inductance, coupling factor, and differential impedance, consistent with the teachings herein. The internal location 502 can connect the inductors to a different (lower) layer of the substrate using vias that allow the signals to be routed elsewhere on the substrate.

FIG. 6 depicts a cross-sectional view of the inductor patterns from FIG. 5 and along the line A-A, consistent with embodiments of the present disclosure. For each of the cross-sectional figures herein, the circles and crosses indicate current flow direction into and out of the page, respectively. The resultant magnetic field direction is also shown. The depicted current flow directions and magnetic fields correspond to common-mode signals in which the respective magnetic fields are constructive or additive. For differential-mode signals, the current direction for one of the coils will be reversed. The resulting magnetic fields will therefore be in opposite directions and counteract each other.

FIG. 7 depicts a pattern in which the inductor traces are arranged in concentric quadrilateral patterns, consistent with embodiments of the present disclosure. Along each side (portion) of the pattern, the two inductor traces run parallel to each other and are closely spaced to provide good magnetic coupling.

FIG. 8 depicts a cross-sectional view of the inductor patterns from FIG. 7 and along the line A-A, consistent with embodiments of the present disclosure. FIG. 8 also depicts the current directions and magnetic field direction for common-mode stimulation. For common-mode stimulation, the current directions are the same for coupled inductor pair. The result is that the magnetic fields from each coil are constructive and result in a corresponding inductance. For differential-mode signals the magnetic fields for each coil will counteract one another, resulting in a reduced effective inductance, where the reduction is relative to inductance seen by common-mode signals having the same frequency.

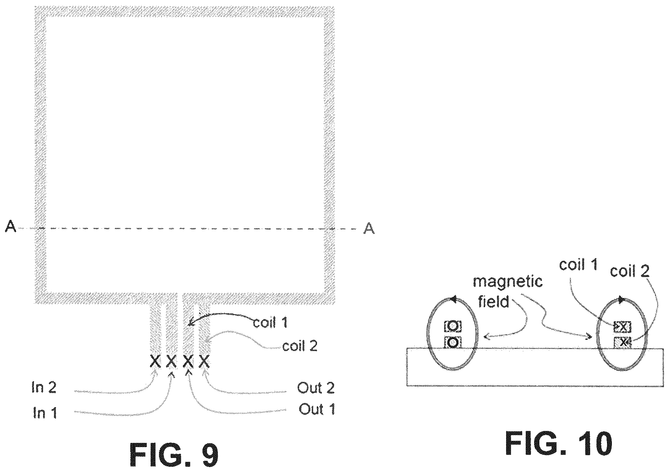

FIG. 9 depicts a pattern in which the inductor traces are arranged in stacked quadrilateral patterns, consistent with embodiments of the present disclosure. In the example depicted in FIG. 10, the coil 2 is located on a lower routing layer relative to coil 1. This configuration can be particularly useful for reducing the amount of surface area consumed on a substrate that has multiple routing layers. While FIG. 9 shows a square pattern, other shapes are possible to stack in a similar manner (e.g., spiral patterns consistent with FIG. 6, or patterns not expressly depicted, such as octagonal patterns).

FIG. 10 depicts a cross-sectional view of the inductors from FIG. 9 and along the line A-A, consistent with embodiments of the present disclosure. FIG. 10 also depicts the current direction and magnetic field direction for the common-mode stimulation. For differential-mode signals the magnetic fields will counteract one another, resulting in a reduced effective inductance (relative to common-mode signals).

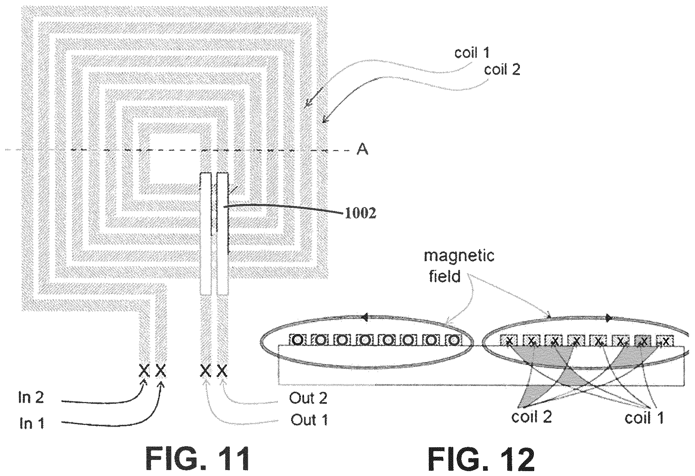

FIG. 11 depicts a pattern in which the inductor traces are arranged as a spiral with straight lines, consistent with embodiments of the present disclosure. Each concentric trace forms a partial quadrilateral. The trace lines 1002, without patterning, represent routing on a different layer of the substrate.

FIG. 12 depicts a cross-sectional view of the inductors from FIG. 11 and along the line A-A, consistent with embodiments of the present disclosure. FIG. 12 also depicts the current direction and magnetic field direction for the common-mode stimulation. For differential-mode signals the magnetic fields will counteract one another, resulting in a reduced effective inductance (relative to common-mode signals).

The inductive structures depicted in FIGs. 5-12, and variants thereof, can be constructed to differential-mode signals at various frequencies and frequency ranges. The data rate of a particular differential signal pair can be used to determine the 1^{st} harmonic, or fundamental frequency (f₀), for the corresponding data signal using the formula: f₀=1/2 data rate. One or more additional harmonics can also be taken into consideration in order to improve the signal quality of the passed differential-mode signal.

As a particular example, USB 3.1 defines high-speed transition as both 5GBit/s and 10GBit/s. The resulting 1^{st} harmonics are 2.5GHz and 5GHz. The resulting 2^{nd} harmonics are 5GHz and 10 GHz. The bandwidth of system can therefore be designed to be equal or greater than these values.

In addition to providing sufficient bandwidth for differential-mode signals, the inductors can be designed to provide sufficient attenuation for common-mode signals, particularly signals consistent with ESD events. As a non-limiting example, the series inductance between the source of the ESD event and the circuitry being protected can be designed to provide sufficient damping of the first (fast) current peak of an ESD discharge (e.g., as defined by IEC61000-4-2). The damping can be roughly modeled based upon the ratio of the effective inductance of the series inductance and the effective inductance of the protection circuitry located near the circuitry being protected. Energy from common-mode signals is shared across both inductances based upon this ratio, with the effect being the suppression current that would otherwise reach the protected circuitry. With this understanding, the series inductance can be designed to provide sufficient suppression based upon knowledge of the inductance of the protection circuitry because, at a given frequency, the reactance of an inductor is proportional to the inductance.

Using USB 3.1 as an example, chips are often designed to withstand about 2 A of current without the requirement of additional protection. Assuming a 15kV discharge of 60 A, the inductance is set to attenuate the 60 A to about 2 A for the relevant frequency components. In a particular non-limiting example, where the inductance of the protection circuitry is around 1 nH. A 30 nH inductor can therefore provide sufficient attenuation for an initial current pulse that is consistent with the IEC61000-4-2 specification. The specific inductive value can vary according to the specific frequency being attenuated as well as the properties of the other components in the system (e.g., the inductance of the circuitry).

Assuming that ESD suppression is sufficient with 30nH coil (Lₙₒₘ) and a known coupling coefficient (k) of 0.94 (or larger) this results in an effective Inductance (L_{eff}) of 1.8nH (or even smaller, with higher k) for differential-mode signals: L_{eff}=Lₙₒₘ- (k*Lₙₒₘ).

The bandwidth, or cutoff frequency, (fg) for the differential signal can be calculated by f_{g}= 1/(2*Pi*sqr(L_{eff}*C_{sys}). Assuming a C_{sys} of ∼0.5 pF, this will lead to a bandwidth of 5.31GHz. Here, C_{sys} represents the sum of capacitance provided by various components in the system (e.g., from ESD protection circuitry, on-chip I/O circuitry, PCB, or other sources).

Aspects of the present disclosure are based upon the recognition that a common mode filter with ceramic core may be insufficient to pass signals with high data rates because the coupling is limited at high frequencies. The reduced coupling is related to losses during reversal of magnetism depending on grain size. The time dependent reversal of magnetism leads to decreasing of bandwidth. Standard materials operate in the MHz range. Even nanoparticle materials have only a high coupling up to the GHz range. Various embodiments are directed toward coils coupled without material with high permeability, such as air coils, which thereby do not show this saturation effect at higher frequencies. The coils can therefore be separated by polymers that do not show losses due to reversal of magnetism of the core material.

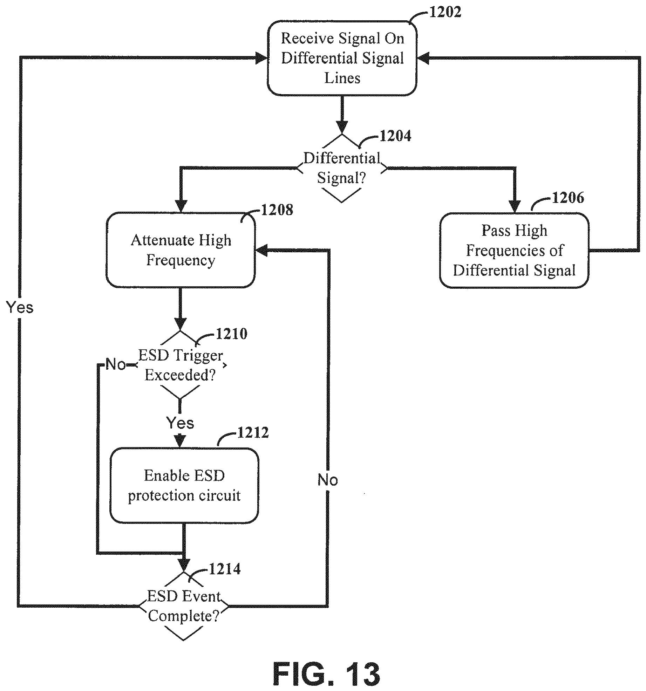

FIG. 13 depicts a flow diagram for using a system or apparatus with an inductive circuit designed to protect against ESD currents, consistent with embodiments of the present disclosure. The flow starts with the reception of a signal on a differential signal line, per block 1202. The received signal can include a common-mode signal (which can be from an ESD event), a differential-mode signal (which can be from a data signal), or both. The system includes an inductive structure with two inductors that are inductively coupled. The inductive structure is therefore configured to implicitly distinguish between common-mode signals and differential-mode signals by providing different respective effective impedances. This differentiation is represented by block 1204. Due to the implicit nature of this distinction, the possible determinations in block 1204 are not exclusive. In other words, at any given moment a signal can contain both common-mode signals and differential-mode signals and each respective path can be followed simultaneously. The differential-mode signals are allowed to pass because the inductive structure has a reduced effective inductance due to the coupling between the individual inductors of the structure, per block 1206.

To the extent that the received signal includes a common-mode signal that is consistent with an electrostatic discharge (ESD) event, the inductive components will attenuate high frequency components of the common-mode signal, per block 1208. Per block 1210 ESD protection circuitry detects an ESD event (e.g., is triggered). In response, the ESD protection circuit is enabled and beings to shunt current, per block 1212. As discussed herein and as consistent with the IEC 61000-4-2 standard, an ESD event can have an initial current spike that is both large in magnitude and short in duration. This can lead to a significant amount of residual ESD current that is not shunted due to the intrinsic inductance of the ESD protection circuit. In such a situation, the attenuation from block 1208 can be relative to residual ESD current that would otherwise reach the protected circuitry. It is recognized that the order of attenuation and current shunting is not necessarily sequential in nature. For example, the ESD protection circuitry can be enabled without (much) attenuation occurring if the received common-mode signal does not contain sufficient high-frequency components during the initial portion of the signal. Moreover, high frequency common-mode signal components can be received and attenuated at any point, whether or not the ESD protection circuitry is enabled. Once the ESD event is completed, the process can restart, per block 1214.

In example embodiments, the ESD protection circuitry may use avalanche breakdown caused by impact ionization in a diode, transistor, or a silicon controlled rectifier (SCR) to shunt ESD current. Other ESD protection solutions are also possible. Some solutions will have different turn-on and turn-off thresholds, which would correspond to the decision blocks 1210 and 1214, respectively.

Terms that indicate orientation, such as upper/lower, left/right, top/bottom and above/below, may be used herein to refer to relative positions of elements as shown in the figures. It should be understood that when the terminology is used for notational convenience, the disclosed structures may be oriented different from the orientation shown in the figures.

For the purposes of this document, the following terms and definitions apply: "signal rise time" refers to the time for a signal to transition between two percentages of the peak signal value, and particularly to 10% to 90% of the peak signal value for purposes of this document; and "planar inductor" refers an inductor with traces or windings located on flat surfaces, in contrast to the helical windings (e.g., around a magnetic core).

The Specification describes and/or illustrates aspects useful for implementing the claimed invention(s) by way of various circuits or circuitry, which may be discussed using terms such as blocks, modules, device, system, unit, controller, comparator, and other circuit-type depictions. Such circuits or circuitry are discussed in connection other elements to explain how certain embodiments may be carried out. For example, in certain of the above-discussed embodiments, one or more illustrated items in this context represent circuits (e.g., discrete analog or logic circuitry or (semi-)programmable circuits) configured and arranged for implementing disclosed operations/activities, as may be carried out in the approaches shown in the figures.

Based upon the above discussion and illustrations, those skilled in the art will readily recognize that various modifications and changes may be made to the various embodiments without strictly following the exemplary embodiments and applications illustrated and described herein. For example, methods as described in connection with the figures may involve steps carried out in various orders, with one or more aspects of the embodiments herein retained, or may involve fewer or more steps. Such modifications do not depart from the true spirit and scope of various aspects of the disclosure, including aspects set forth in the claims.

## Claims

1. An apparatus comprising:
a first inductive component connected in series with a first signal line of a differential signal path and configured to suppress electrostatic discharge (ESD) current spikes on the first signal line by using a first effective inductance; and
a second inductive component connected in series to a second signal line of the differential signal path configured to suppress ESD current spikes on the second signal line of the differential signal path by using a second effective inductance,
the first and second inductive components configured to pass differential signals on the differential signal path by using inductive coupling between the first and second inductive components to provide a third effective inductance.

2. The apparatus of claim 1, wherein the first and second inductive components are configured to attenuate ESD current spikes having a rise time of Ins or less.

3. The apparatus of claim 2, wherein the first and second inductive components are configured to pass differential signals having a rise time of Ins or less.

4. The apparatus of claim 1, wherein the first and second inductive components include first and second inductive coils having layout path sections where each path is substantially parallel to the other.

5. The apparatus of claim 1, further comprising an ESD protection circuit configured to provide ESD protection to circuitry connected to the signal lines by shunting ESD event current to a reference voltage.

6. The apparatus of claim 5, wherein the first and second inductive components are configured to suppress frequency components generated by an initial ESD current spike of the ESD event and the ESD protection circuit is configured to shunt, to the reference voltage, ESD event current not shunted as part of the initial ESD current spike.

7. The apparatus of claim 5, wherein the first and second inductive components are located on a printed circuit board (PCB) and wherein the circuitry is an integrated circuit (IC) chip located on the PCB.

8. The apparatus of claim 5, wherein the circuitry is a first integrated circuit (IC) chip on a printed circuit board (PCB) and wherein the first and second inductive components are located on a second IC chip on the PCB.

9. The apparatus of claim 1, wherein the inductive coupling between the first and second inductive components is provided without the use of a magnetic core for the first and second inductive components, wherein the first and second inductive components are isolated from one another by at least one material selected from the group consisting of air and a polymer, and wherein the inductive components include conductive traces placed with in proximity sufficient to provide a coupling factor of at least 0.9.

10. A method comprising:
receiving an electrostatic discharge (ESD) event on signal lines forming a differential signal path;
shunting, using an ESD protection circuit, ESD current from an ESD event;
suppressing residual ESD current from the ESD event using effective inductance provided by inductive components connected in series with the signal lines;
receiving a differential signal on the signal lines forming the differential signal path; and
passing the differential signal by using inductive coupling between the inductive components to reduce the effective inductance provided by the inductive components.

11. The method of claim 10, wherein the suppressing includes an attenuation sufficient to attenuate, by a factor of at least 20, ESD frequency components corresponding to at least a 30A pulse of no more than 1 nanosecond in duration.

12. The method of claim 11, wherein the attenuation is by a factor of at least 30, and the differential signal has a rise time of 600 ps or less.

13. The method of claim 10, wherein the residual current from frequency components with frequencies between 25 MHz and 1.0 GHz, and frequency components of the differential signal passed by using the inductive coupling include frequencies between 25 MHz and 1.0 GHz.

14. The method of claim 10, further comprising using another ESD protection circuit to shunt a portion of the ESD current corresponding to the attenuated ESD current.

15. The method of claim10, wherein the inductive coupling between the inductive components is provided using a non-magnetic core between the inductive components.
